# EUROPEAN PATENT SPECIFICATION

(11) **EP 4 412 432 B1**
(45) Date of publication and mention of the grant of the patent: **09.12.2026**
(21) Application number: 24153298.5
(22) Date of filing: 23.01.2024
(51) Int. Cl.: H10K 59/35, H10K 59/122, H10K 59/38

(54) **DISPLAY DEVICE AND METHOD OF MANUFACTURING THE SAME**
ANZEIGEVORRICHTUNG UND VERFAHREN ZUR HERSTELLUNG DAVON
DISPOSITIF D'AFFICHAGE ET SON PROCÉDÉ DE FABRICATION

(30) Priority: 01.02.2023 CN 202310102278
(43) Date of publication of application: 07.08.2024
(73) Proprietor: Taizhou Guanyu Technology Co., Ltd., Taizhou City, Zhejiang Province (CN)
(72) Inventor: HSU, KUO-CHENG, 406 TAICHUNG CITY (TW)
(74) Representative: Michalski Hüttermann & Partner mbB

(56) References cited:
- WO-A1-2019/134447
- CN-A- 114 512 521
- CN-A- 115 377 146
- TW-B- I 585 968
- US-A1- 2020 411 602
- US-A1- 2022 140 288
- US-A1- 2022 310 712

## Description

### CROSS REFERENCE TO RELATED APPLICATIONS

This application claims the benefit of CN Application No. 202310102278.9, filed on February 1, 2023.

### BACKGROUND OF THE PRESENT DISCLOSURE

### FIELD OF THE PRESENT DISCLOSURE

The present disclosure relates to display devices and, more particularly, to a display device comprising pixels each having a specific profile.

### DESCRIPTION OF THE PRIOR ART

Display devices each including optical component layers are widely applied to most electronic apparatuses. In recent years, there is demand to upsize the display devices. However, conventional methods of manufacturing the display devices are disadvantaged by a step in which light output efficiency is poor. In fact, one of the well-known challenges to persons skilled in the art is the enhancement of the light output efficiency of the display devices. In view of this, display device manufacturers are looking for a solution to the aforesaid problem.

WO 2019/134447 A1 discloses a pixel arrangement structure, an organic electroluminescent display panel, a metal mask, and a display device. The pixel arrangement structure comprises: multiple sub-pixels not overlapped in position and spaced apart from each other. The multiple sub-pixels comprise multiple first sub-pixels, multiple second sub-pixels, and multiple third sub-pixels. US 2020/4111602 A1 discloses a display panel including at least two first pixels, at least two second pixels, and at least two third pixels. An area of the first pixel, an area of the second pixel, and an area of the third pixel are inversely proportional to a luminous efficiency of a luminescent material of the first pixel, a luminous efficiency of a luminescent material of the second pixel, and a luminous efficiency of a luminescent material of the third pixel, respectively. The disclosure can avoid the drawback of color shift of the display panel. TW I 585 968 B discloses a display device comprising: a group of pixels including: a first pixel comprising only a red subpixel and a blue subpixel; a second pixel comprising only a green subpixel and a blue subpixel; a third pixel comprising only a green subpixel and a blue subpixel; and a fourth pixel comprising a red subpixel and a blue subpixel, respectively. wherein the first and second pictograms are adjacent to each other and are arranged in a row, the first and third pictograms are adjacent to each other and are arranged in a row, the fourth pictogram is opposite to the first pictogram and the fourth pictogram is adjacent to the second and third pictograms, wherein within the group of pictograms, the sum of the numbers of the blue pictograms is greater than the sum of the numbers of the red pictograms, and the sum of the numbers of the blue pictograms is greater than the sum of the numbers of the green pictograms. US 2022/310712 A1 discloses a method and apparatus for optimizing a pixel arrangement, a light-transmitting display panel, and a display panel. A light-transmitting display panel, includes: an array substrate; and a light-emitting layer positioned on the array substrate, the light-emitting layer comprising a plurality of pixel units, a plurality of first electrodes of respective sub-pixels in the plurality of pixel units being arranged in a pattern, and a combination of graphic parameters and position parameters of the plurality of first electrodes arranged in the pattern enabling zero-order diffraction spot energy of the light-transmitting display panel and light transmission energy of the light-transmitting display panel satisfying a following relationship expression: I₀/Iₓ ≥ 85%, wherein I₀ represents the zero-order diffraction spot energy of the light-transmitting display panel, and Iₓ represents the light transmission energy of the light-transmitting display panel. US 2022/140288 A1 a display apparatus including a display element including an emission area, a thin-film encapsulation layer disposed on the display element, a first insulating layer disposed on the thin-film encapsulation layer, the first insulating layer including an opening that corresponds to the emission area, and a refraction area defined by the opening and including an organic material, and a second insulating layer disposed on the first insulating layer, filling the refraction area, and having a refractive index greater than a refractive index of the first insulating layer, wherein the display element includes a first display element and a second display element, and the refraction area has a circular shape or an elliptical shape in a plan view and includes a first refraction area corresponding to the first display element and a second refraction area corresponding to the second display element. CN 115 377 146 A discloses a display substrate and a display device, and the display substrate is provided with a plurality of sub-pixels which are arranged in an array. The driving circuit layer is arranged on the substrate, the pixel defining layer is arranged on the side, away from the substrate, of the driving circuit layer, and the black matrix layer is arranged on the side, away from the substrate, of the light emitting device layer. Each of the plurality of sub-pixels includes a pixel driving circuit disposed in the driving circuit layer and a light emitting device disposed in the light emitting device layer, and the pixel driving circuit is configured to drive the light emitting device. The black matrix layer is provided with a plurality of first light-transmitting openings which expose the light-emitting devices of the sub-pixels in the direction perpendicular to the plate face of the substrate, the pixel defining layer comprises a plurality of sub-pixel openings, and at least part of the sub-pixel openings are in one-to-one correspondence with the first light-transmitting openings and at least partially overlapped with the first light-transmitting openings. At least one of the plurality of first light-transmitting openings has an arc-shaped edge. The display substrate has a better display effect. CN 114 512 521 discloses a pixel arrangement structure, a display panel and a display device. The pixel arrangement structure comprises a plurality of pixel units which are arranged repeatedly, the pixel units are arranged in rows in the first direction and arranged in columns in the second direction intersecting with the first direction, the pixel units in every two adjacent rows are arranged in a staggered mode in the first direction, and the pixel units in every two adjacent rows are arranged in a staggered mode in the second direction. Two adjacent columns of pixel units are arranged in a staggered manner in the second direction; each pixel unit comprises a first sub-pixel, a second sub-pixel and a third sub-pixel of which the center connecting lines form a virtual triangle; wherein the connecting line of the centers of the first sub-pixel and the second sub-pixel forms a virtual edge of the virtual triangle along the second direction, and a straight line which passes through the center of the third sub-pixel and is parallel to the first direction intersects with the virtual edge of the virtual triangle along the second direction; the area of the third sub-pixel is larger than the area of the first sub-pixel and the area of the second sub-pixel. The pixel arrangement structure can solve the problem that the display effect of an OLED display device is affected by the characteristics of an organic light-emitting material.

### SUMMARY OF THE PRESENT DISCLOSURE

A display device comprises a first pixel and a second pixel. The first pixel is adapted to emit light of a first color, wherein the profile of the first pixel is elliptical. The second pixel is adapted to emit light of a second color different from the first color, wherein the profile of the second pixel is round. The profile of the first pixel meets that a ratio of the length of a long axis to the length of a short axis is greater than 1 but less than The first pixel has a first pixel unit, a second pixel unit, and a third pixel unit. The first pixel unit (1214) is located at a first row, the second pixel unit (1215) is located at a second row and the third pixel unit (1216) is located at a third row. The first pixel unit is aligned with the third pixel unit along a first direction (Y) and misaligned with the second pixel unit along the first direction and a second direction (X) substantially orthogonal to the first direction, an extending direction of a long axis of first pixel unit is nonparallel to the first direction and the second direction and is nonparallel to an extending direction of a long axis of second pixel unit, and an extending direction of a long axis of third pixel unit is parallel to the extending direction of the long axis of the first pixel unit

A method of manufacturing a display device comprises forming a first pixel and forming a second pixel. The first pixel is adapted to emit light of a first color, wherein a profile of the first pixel is elliptical. The second pixel is adapted to emit light of a second color different from the first color, wherein a profile of the second pixel is round. The profile of the first pixel meets that a ratio of the length of a long axis to the length of a short axis is greater than 1 but less than 1.25, wherein the first pixel has a first pixel unit, a second pixel unit (1215), and a third pixel unit. The first pixel unit (1214) is located at a first row, the second pixel unit (1215) is located at a second row and the third pixel unit (1216) is located at a third row. The first pixel unit is aligned with the third pixel unit along a first direction and misaligned with the second pixel unit along the first direction and a second direction substantially orthogonal to the first direction, an extending direction of a long axis of first pixel unit is nonparallel to the first direction and the second direction and is nonparallel to an extending direction of a long axis of second pixel unit, and an extending direction of a long axis of third pixel unit is parallel to the extending direction of the long axis of the first pixel unit.

### BRIEF DESCRIPTION OF THE DRAWINGS

FIG. 1A is a top view of a display device according to some embodiments of the disclosure, not forming part of the claimed invention.
FIG. 1B is a cross-sectional view of the display device taken along line A-A' of FIG. 1A.
FIG. 2A is a top view of a display device according to the claimed invention.
FIG. 2B is a cross-sectional view of the display device taken along line B-B' of FIG.
FIG. 3 is a top view of a display device according to some embodiments of the disclosure, not forming part of the claimed invention.
FIGS. 4A, 4B, 4C, 4D and 4E are schematic views of the display device in different stages of a manufacturing process carried out with a method according to the claimed invention.

### DETAILED DESCRIPTION OF THE EMBODIMENTS

Different embodiments or examples are herein provided to illustrate how to implement various features of the disclosure. The specific examples of components and arrangement thereof are aimed at rendering the disclosure easy to understand. However, the examples are illustrative rather than restrictive of the disclosure. For instance, an embodiment of "forming a first feature on or above a second feature," as described below, may include another embodiment of "forming first and second features in direct contact with each other," or include yet another embodiment of "forming another feature between the first and second features, thereby precluding direct contact between the first and second features." Furthermore, reference numerals and/or signs may repeat in different examples herein; the repetition simplifies and clarifies the embodiments rather than defines the relation between the embodiments and/or features disclosed therein.

Position-related expressions, such as "under," "lower than," "low," "higher than," and "high," are used herein to describe the relation between a component/feature and another component/feature in the accompanying drawings. The position-related expressions may also indicate any directions not depicted in the accompanying drawings, for example, directions in which apparatuses are used or operated. Alternatively, the apparatuses can be positioned (rotated by 90 degrees or the like) in place, and the position-related expressions are still applicable.

Although all the numerical value ranges and parameters widely disclosed in the disclosure are approximations, the numerical values are stated as precisely as possible in specific embodiments. However, intrinsically, every numerical value inevitably comes with some errors arising from a standard deviation associated with individual testing measurement. Moreover, the expression "approximately" used hereunder means being not 10%, 5%, 1%, or 0.5% greater or less than a given value or being not falling outside the upper or lower limit of a range by 10%, 5%, 1%, or 0.5%. Alternatively, the expression "approximately" used hereunder means falling within the standard error regarded by persons skilled in the art as acceptable to the mean. Understandably, except for operation-related or work-related examples, or unless otherwise specified, all numerical value ranges, quantity, values, and percentages (for example, descriptive of the amount of a material used, time period, temperature, operation conditions, quantitative proportion, and the like) used hereunder are defined by the expression "approximately" in all situations. Therefore, unless otherwise specified, all numerical values and parameters disclosed hereunder and in the claims are approximations and are subject to changes as needed. At the very least, the numerical values and parameters must be interpreted in accordance with the reported number of significant figures and a general carry system. In this regard, a numerical value range is expressed as starting from an endpoint and ending at another endpoint or as lying between two endpoints. Unless otherwise specified, every numerical value range includes endpoints.

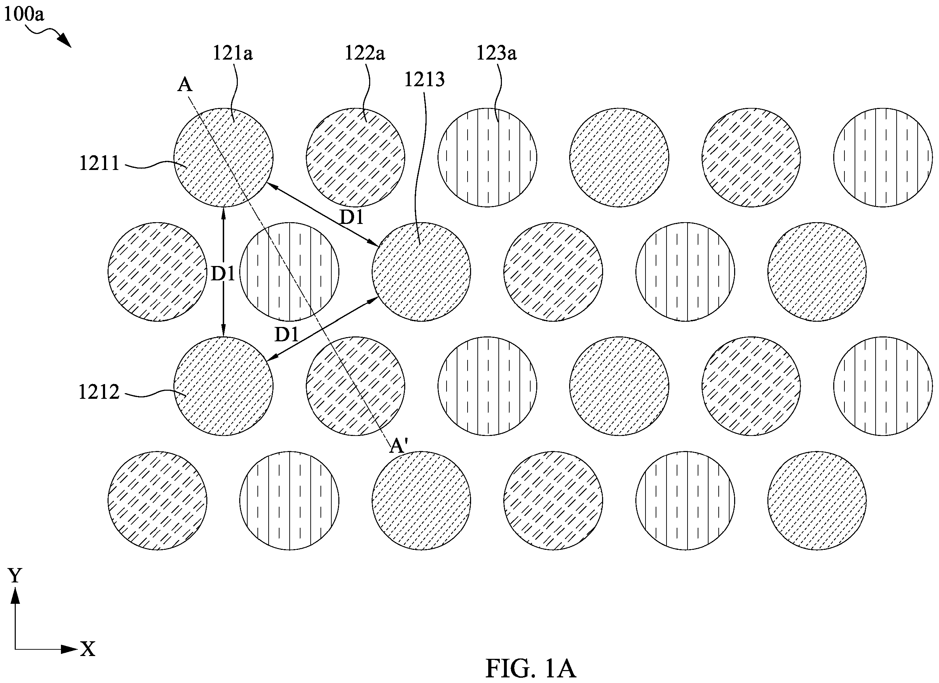

FIG. 1A is a top view of a display device 100a according to some embodiments of the disclosure, not forming part of the claimed invention.

In some embodiments, the display device 100a comprises pixels 121a, 122a and 123a. The pixels 121a, 122a and 123a are aligned in a row direction (for example, X direction) repeatedly, consecutively, and alternately. In some embodiments, the pixels 121a, 122a and 123a in a first row shift relative to the pixels 121a, 122a and/or 123a in a second row in X direction, respectively. The pixels 121a, 122a and 123a in the first row are aligned with the pixels 121a, 122a and 123a in a third row in Y direction, respectively. In some embodiments, the pixel 121a is configured to emit light of a first color, the pixel 122a is configured to emit light of a second color, and the pixel 123a is configured to emit light of a third color. In some embodiments, the light of the first color comprises green light (for example, light with wavelength ranging from 500nm to 580nm), the light of the second color comprises red light (for example, light with wavelength ranging from 620nm to 780nm), and the light of the third color comprises blue light (for example, light with wavelength ranging from 400nm to 500nm).

In some embodiments, the profile of the pixel 121a is round in shape. In some embodiments, the profile of the pixel 122a is round in shape. In some embodiments, the profile of the pixel 123a is round in shape.

In some embodiments, the pixel 121a comprises pixel units 1211, 1212, 1213 located at a first row, third row and second row, respectively. In some embodiments, the distances between any two adjacent ones of the pixel units are substantially the same. In some embodiments, any two adjacent ones of the pixel units are located at adjacent rows, respectively. For example, the pixel unit 1211 and the pixel unit 1212 are separated by distance D1. The pixel unit 1212 and the pixel unit 1213 are separated by distance D1. The pixel unit 1211 and the pixel unit 1213 are separated by distance D1. In some embodiments, the distances between any two adjacent ones of the pixel units (not denoted with any reference numeral) of the pixel 122a are substantially the same. In some embodiments, the distances between any two adjacent ones of the pixel units (not denoted with any reference numeral) of the pixel 123a are substantially the same.

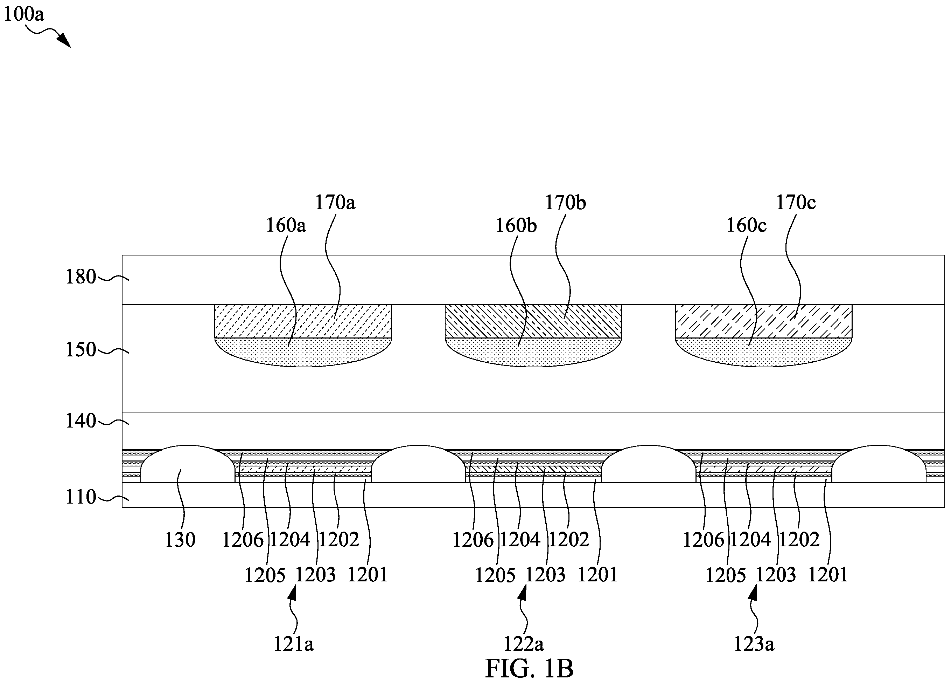

FIG. 1B is a cross-sectional view of the display device 100a taken along line A-A' of FIG. 1A.

In some embodiments, the display device 100a further comprises a substrate 110, a pixel definition layer 130, a flat layer 140, a filling layer 150, optical component layers 160a, 160b, 160c, filter layers 170a, 170b, 170c, and a cover panel 180.

In some embodiments, the substrate 110 comprises a base (not shown), a dielectric layer (not shown), and one or more circuits (not shown) disposed on or in the base. In some embodiments, the base is a transparent base, or at least part of the base is transparent. In some embodiments, the base is a non-flexible base, and the base is made of a material, such as glass, quartz, low-temperature poly-silicon (LIPS) or any other appropriate materials. In some embodiments, the base is a flexible base, and the base is made of a material, such as transparent epoxy resin, polyimide (PI), polyvinyl chloride (PVC), methyl methacrylate (MMA) or any other appropriate materials. The dielectric layer is disposed on the base as needed. In some embodiments, the dielectric layer is made of a material, such as silicon oxide, nitridosilicate, silicon oxynitride or any other appropriate materials.

In some embodiments, the circuits are complementary metal-oxide-semiconductor (CMOS) circuits or each comprise a plurality of transistors and a plurality of capacitors adjacent to the transistors, wherein the transistors and capacitors are formed on the dielectric layer. In some embodiments, the transistors are thin-film transistors (TFT). The transistors each comprise a source/drain region (comprising at least one source region and one drain region), a channel region between the source/drain region, a gate electrode disposed above the channel region, and a gate insulator between the channel region and the gate electrode. The channel regions of the transistors are made of semiconductor materials, such as, silicon or any other elements selected from group IV or III elements and group V elements.

In some embodiments, the substrate 110 comprises an interlayer dielectric structure and a first metallic layer. The interlayer dielectric structure is disposed on the circuits or transistors. The first metallic layer is electrically connected to the pixels 121a, 122a and/or 123a.

The pixels 121a, 122a and 123a are disposed on the substrate 110. In some embodiments, the pixels 121a, 122a and 123a are each an organic light-emitting diode (LED), a micro LED or mini LED, a quantum dot LED (QLED) or any other appropriate pixel.

In some embodiments, the pixels 121a, 122a and 123a each comprise an electrode 1201, a carrier injection layer 1202, a carrier transmission layer 1203, an emissive layer (EML) 1204, a carrier transmission layer 1205, and an electrode 1206.

The electrode 1201 is disposed on the surface of the substrate 110. The electrodes 1201 are each configured to have: one side connected to a circuit embedded in or electrically connected to the substrate 110, and the other side in contact with the carrier injection layer 1202. The electrode 1201 is made of a metallic material, for example, Ag and Mg. In some embodiments, the electrode 1201 is made of indium tin oxide (ITO), indium zinc oxide (IZO) or any other appropriate materials.

The carrier injection layer 1202 is disposed on the electrode 1201. In some embodiments, the carrier injection layer 1202 is for use in hole injection. In some embodiments, the carrier injection layer 1202 is for use in electron injection. In some embodiments, the carrier injection layer 1202 is in contact with the pixel definition layer 130. In some embodiments, the carrier injection layer 1202 is made of an organic compound. In some embodiments, the carrier injection layer 1202 is a composite structure.

The carrier transmission layer 1203 is disposed on the carrier injection layer 1202. In some embodiments, the carrier transmission layer 1203 is a hole transportation layer (HTL). In some embodiments, the carrier transmission layer 1203 is an electron transportation layer (ETL). In some embodiments, the carrier transmission layer 1203 is in contact with the pixel definition layer 130. In some embodiments, the carrier transmission layer 1203 is made of an organic compound. In some embodiments, the carrier transmission layer 1203 is characterized by unidirectional (for example, in the direction from the electrode 1201 to the electrode 1206) transmission of electrons or holes. In some embodiments, the carrier transmission layer 1203 is a composite structure.

The emissive layer 1204 is disposed on the carrier transmission layer 1203. The emissive layer 1204 covers the carrier transmission layer 1203 completely. In some embodiments, the emissive layers 1204 of the pixel 121a, pixel 122a and pixel 123a are made of different materials to emit light beams of different wavelengths, respectively. For example, the emissive layer 1204 of the pixel 122a is configured to emit light of a first color, the emissive layer 1204 of the pixel 121a is configured to emit light of a second color, and the emissive layer 1204 of the pixel 123a is configured to emit light of a third color.

The carrier transmission layer 1205 is disposed on the emissive layer 1204. In some embodiments, the carrier transmission layer 1205 is an electron transportation layer. In some embodiments, the carrier transmission layer 1205 is a hole transportation layer. In some embodiments, the carrier transmission layer 1205 and the carrier transmission layer 1203 are arranged to be in opposite valence states. In some embodiments, the carrier transmission layer 1205 is a composite structure.

The electrode 1206 is disposed on the carrier transmission layer 1205. The electrode 1206 is made of a metallic material, for example, Ag and Mg. In some embodiments, the electrode 1206 is made of indium tin oxide (ITO), indium zinc oxide (IZO) or any other appropriate materials.

The pixel definition layer 130 is disposed between two pixels (for example, the pixels 121a, 122a and 123a). The opening of the pixel definition layer 130 is used to define the light emission areas and/or profiles of the aforesaid pixels. In some embodiments, the pixel definition layer 130 is made of a light absorbing material whose absorbance is greater than 85%, for example, 85%, 88%, 90%, 93%, 95%, 97%, 98% or 99%. In some embodiments, the pixel definition layer 130 is made of a light penetrable material whose transmittance is greater than 85%, for example, 85%, 88%, 90%, 93%, 95%, 97%, 98% or 99%. The pixel definition layer 130 is made of a dielectric material.

In some embodiments, the profile of the opening of the pixel definition layer 130 is round in shape. In some embodiments, the opening of the pixel definition layer 130 is adapted to contain the electrode 1201, the carrier injection layer 1202, the carrier transmission layer 1203, the emissive layer 1204, the carrier transmission layer 1205 and/or the electrode 1206.

In some embodiments, the profiles of the electrode 1201, the carrier injection layer 1202, the carrier transmission layer 1203, the emissive layer 1204, the carrier transmission layer 1205 and/or the electrode 1206 are round in shape.

The flat layer 140 is disposed on the substrate 110. The flat layer 140 covers the pixel 121a, pixel 122a, pixel 123a and pixel definition layer 130 and provides a flat upper surface. The flat layer 140 is made of an oxide, a nitride or any other dielectric materials.

The filling layer 150 is disposed on the flat layer 140. The filling layer 150 is made of a substantially transparent material, for example, resin or any other appropriate materials, and comprises any filler. The transmittance of the filling layer 150 is greater than 85%, for example, 85%, 88%, 90%, 93%, 95%, 97%, 98% or 99%.

In some embodiments, the optical component layers 160a, 160b and 160c are disposed in the filling layer 150. The optical component layer 160a is not only disposed on the pixel 121a but also aligned with the pixel 121a in the longitudinal direction. The optical component layer 160b is not only disposed on the pixel 122a but also aligned with the pixel 122a in the longitudinal direction. The optical component layer 160c is not only disposed on the pixel 123a but also aligned with the pixel 123a in the longitudinal direction. In some embodiments, the optical component layers 160a, 160b and 160c are adapted to alter the light paths of the light beams emitted from the pixels. In some embodiments, the optical component layers 160a, 160b and 160c each comprise a lens or any other appropriate components. In some embodiments, the optical component layers 160a, 160b and 160c have profiles that protrude toward the substrate 110. In some embodiments, in a top view, the optical component layer 160a, optical component layer 160b and/or optical component layer 160c each has substantially the same profile as the pixel 121a, 122a and/or 123a. In some embodiments, in a top view, the profiles/profile of the optical component layer 160a, optical component layer 160b and/or optical component layer 160c are/is round in shape.

As shown in FIG. 1B, the filter layer 170a is not only disposed on the optical component layer 160a but also aligned with the optical component layer 160a in the longitudinal direction. The filter layer 170b is not only disposed on the optical component layer 160b but also aligned with the optical component layer 160b in the longitudinal direction. The filter layer 170c is not only disposed on the optical component layer 160c but also aligned with the optical component layer 160c in the longitudinal direction. The filter layers 170a, 170b and 170c are penetrable by light beams of different wavelengths, respectively. For example, the filter layer 170a is penetrable or transmissive by green light (for example, light with wavelength ranging from 500nm to 580nm), the filter layer 170b is penetrable or transmissive by red light (for example, light with wavelength ranging from 620nm to 780nm), and the filter layer 170c is penetrable or transmissive by blue light (for example, light with wavelength ranging from 400nm to 500nm). In some embodiments, in a top view, the filter layers 170a, 170b and/or 170c each have substantially the same profile as the pixels 121a, 122a and/or 123a. In some embodiments, the filter layers 170a, 170b and 170c can be dispensed with.

The cover panel 180 is disposed on the filter layers 170a, 170b and 170c. In some embodiments, the cover panel 180 comprises a substantially transparent component, for example, glass or any other appropriate components.

In an embodiment of the disclosure, the profile of the opening of the pixel definition layer 130 and the profiles of the pixels 121a, 122a and 123a are round in shape. It is desirable to define the opening of the pixel definition layer 130. When the profile of the opening of the pixel definition layer 130 meets that the ratio of the length of a long axis to the length of a short axis is greater than 1 but less than 1.25, the tension of the pixel definition layer 130 is kept within a relatively appropriate range conducive to the reduction in the difference (caused by an error of a photolithography process) between a resultant profile of the pixel definition layer 130 and the expected profile thereof, so as to ensure that the pixels 121a, 122a and 123a have the same size.

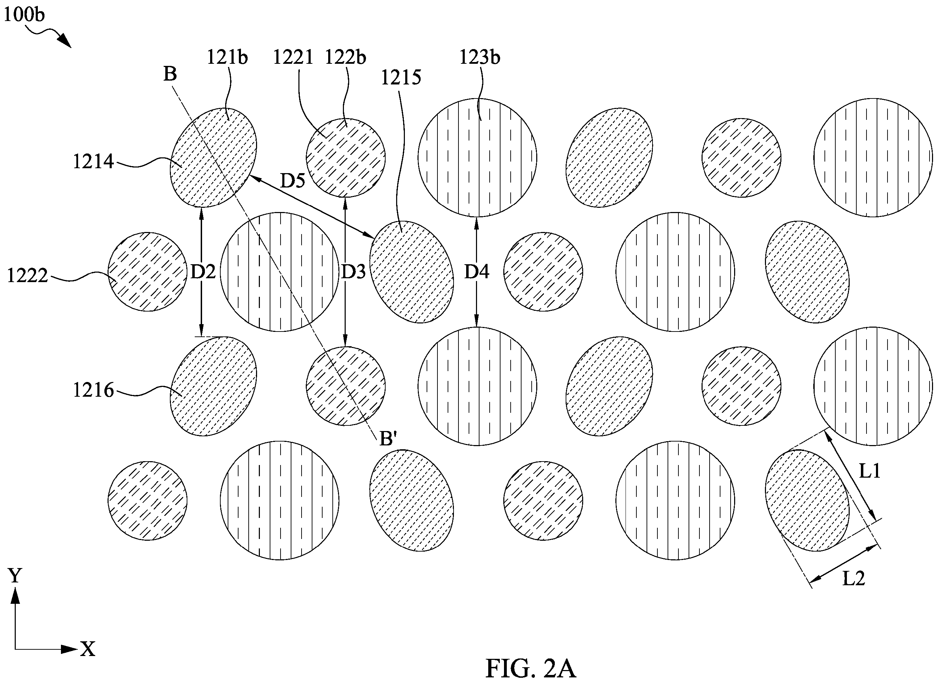

FIG. 2A is a top view of a display device 100b according to the claimed invention. The display device 100b is distinguished from the display device 100a by the technical features described below.

The display device 100b comprises pixels 121b, 122b and 123b. The pixels 121b, 122b and 123b have different profiles. In some embodiments, the pixels 121b, 122b and 123b have different sizes. In some embodiments, the pixels 121b, 122b and 123b have different surface areas

In the claimed invention, the pixel 121b has an elliptical profile. The ratio of the length of long axis L1 of the pixel 121b to the length of short axis L2 of the pixel 121b is greater than 1 but less than 1.25, for example, is equal to 1.05, 1.1, 1.5, 1.2, 1.21, 1.22, 1.23, 1.24 or 1.245. The pixel 121b has a pixel unit 1214, pixel unit 1215 and pixel unit 1216. The pixel unit 1214 is located at a first row. The pixel unit 1215 is located at a second row. The pixel unit 1216 is located at a third row. The profile orientation of the pixel unit 1214 is different from the profile orientation of the pixel unit 1215. The profile orientation of the pixel unit 1214 is the same as the profile orientation of the pixel unit 1216. The profile orientation of the pixel unit 1214 and the profile orientation of the pixel unit 1215 may be mirror images to each other. For example, after the pixel unit 1214 has been rotated about Y-axis by 180 degrees, the profile orientation of the pixel unit 1214 becomes identical to the profile orientation of the pixel unit 1215. The pixel 122b has a pixel 1221 and a pixel 1222. The pixel 1221 is located at a first row. The pixel 1222 is located at a second row. In some embodiments, the profile of the pixel 1221 is identical to the profile of the pixel 1222.

The pixel unit 1214 and the pixel unit 1216 are separated by distance D2. Two adjacent pixels 122b are separated by distance D3. Two adjacent pixels 123b are separated by distance D4. The pixel unit 1214 and the pixel unit 1215 are separated by distance D5. In some embodiments, distance D2 is not equal to distance D3. In some embodiments, distance D3 is not equal to distance D4. In some embodiments, distance D2 is not equal to distance D4. In some embodiments, distance D2 is substantially equal to distance D5.

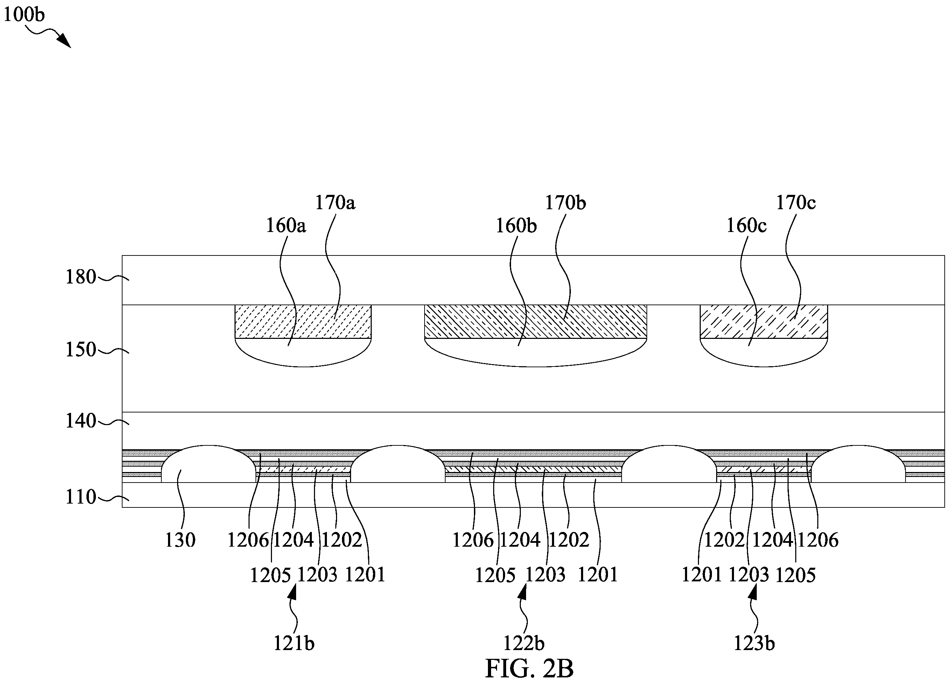

FIG. 2B is a cross-sectional view of the display device taken along line B-B' of FIG. 2A.

In some embodiments, in a top view, the opening of the pixel definition layer 130 is defined to have an elliptical and/or round profile. Regarding the opening of the pixel definition layer 130, the ratio of the length of its long axis and the length of its short axis is greater than 1 but less than 1.25, for example, is equal to 1.05, 1.1, 1.5, 1.2, 1.21, 1.22, 1.23, 1.24 or 1.245.

The optical component layers 160a, 160b and 160c have the same profile as the pixels 121b, 122b and 123b, respectively. The optical component layers 160a, 160b and 160c have the same size as the pixels 121b, 122b and 123b, respectively. In some embodiments, the optical component layers 160a, 160b and 160c have different profiles. In some embodiments, the optical component layers 160a, 160b and 160c have different sizes. In some embodiments, in a top view, the ratio of the length of the long axis of the optical component layer 160a to the length of the short axis of the optical component layer 160a is greater than 1 but less than 1.25, for example, is equal to 1.05, 1.1, 1.5, 1.2, 1.21, 1.22, 1.23, 1.24 or 1.245.

The filter layers 170a, 170b and 170c have the same profile as the pixels 121b, 122b and 123b, respectively. The filter layers 170a, 170b and 170c have the same size as the pixels 121b, 122b and 123b, respectively. In some embodiments, the filter layers 170a, 170b and 170c have different profiles. In some embodiments, the filter layers 170a, 170b and 170c have different sizes. In some embodiments, in a top view, the ratio of the length of the long axis of the filter layer 170a to the length of the short axis of the filter layer 170a is greater than 1 but less than 1.25, for example, is equal to 1.05, 1.1, 1.5, 1.2, 1.21, 1.22, 1.23, 1.24 or 1.245.

In this embodiment, the pixel 121a has an elliptical profile, and the tension of the pixel definition layer 130 is kept within a relatively appropriate range conducive to the reduction in the difference (caused by an error of a photolithography process) between a resultant profile of the pixel definition layer 130 and the expected profile thereof when the ratio of the length of the long axis of the pixel 121a to the length of the short axis of the pixel 121a is greater than 1 but less than 1.25.

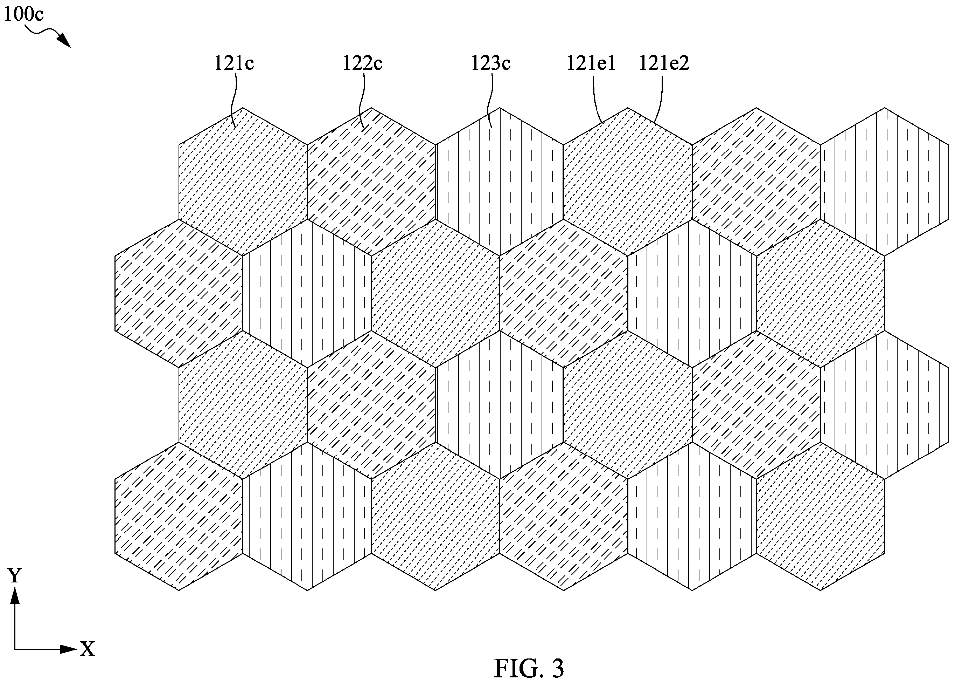

FIG. 3 is a top view of a display device 100c according to some embodiments of the disclosure, not forming part of the claimed invention. The display device 100c is distinguished from the display device 100a by the technical features described below.

In some embodiments, the display device 100c comprises pixels 121c, 122c and 123c. In some embodiments, the pixels 121c, 122c and 123c have polygonal profiles. In some embodiments, the pixels 121c, 122c and 123c have regular hexagonal profiles. In other embodiments, each profile of the pixels 121c, 122c and 123c is one of a pentagon, octagon, decagon and dodecagon. In some embodiments, the pixels 121c, 122c and 123c each have a side 122e1 and a side 122e2. In some embodiments, the side 122e1 and the side 122e2 are equal in length. In some embodiments, the side 122e1 and the side 122e2 are different in length. In some embodiments, the side 122e1 is a long side (or the longest side), whereas the side 122e2 is a short side (or the shortest side), and the ratio of the length of the side 122e1 to the length of the side 122e2 is greater than 1 but less than 1.25, for example, is equal to 1.05, 1.1, 1.5, 1.2, 1.21, 1.22, 1.23, 1.24 or 1.245.

In this embodiment, the pixels 121c, 122c and 123c have polygonal profiles, and the tension of the pixel definition layer 130 is kept within a relatively appropriate range conducive to the reduction in the difference (caused by an error of a photolithography process) between a resultant profile of the pixel definition layer 130 and the expected profile thereof when the ratio of the length of their long side to the length of their short side is greater than 1 but less than 1.25.

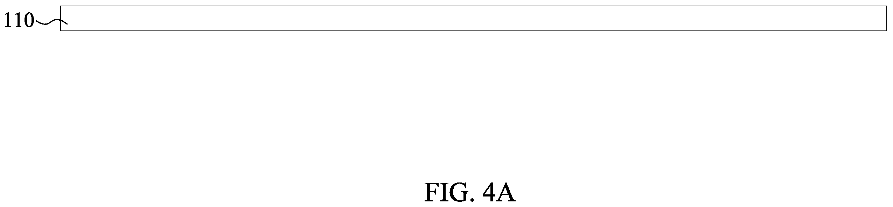

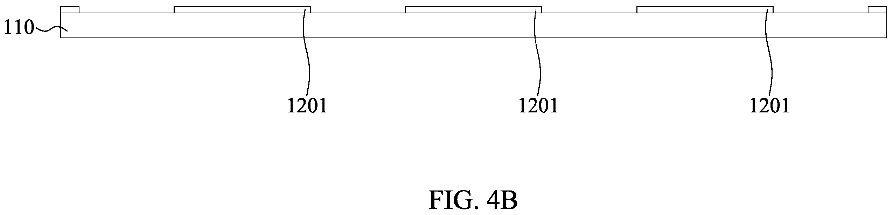

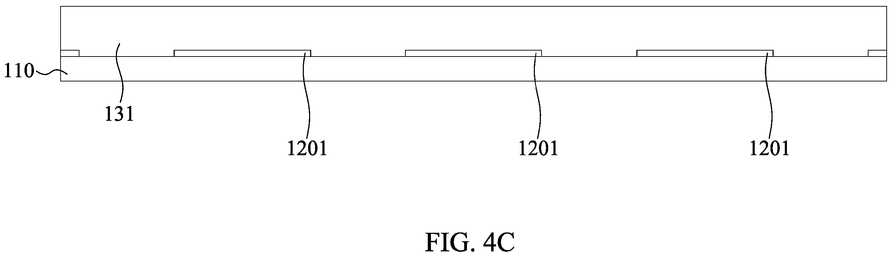

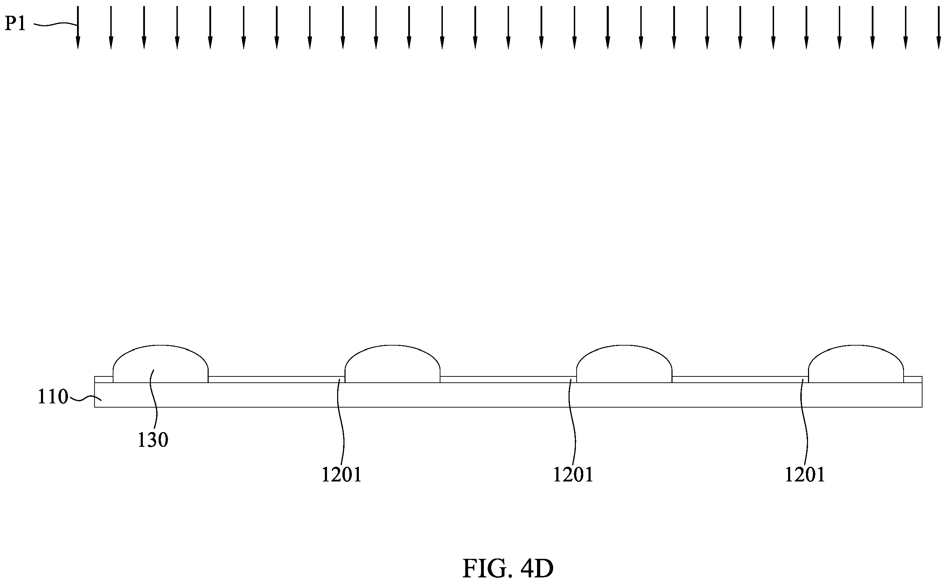

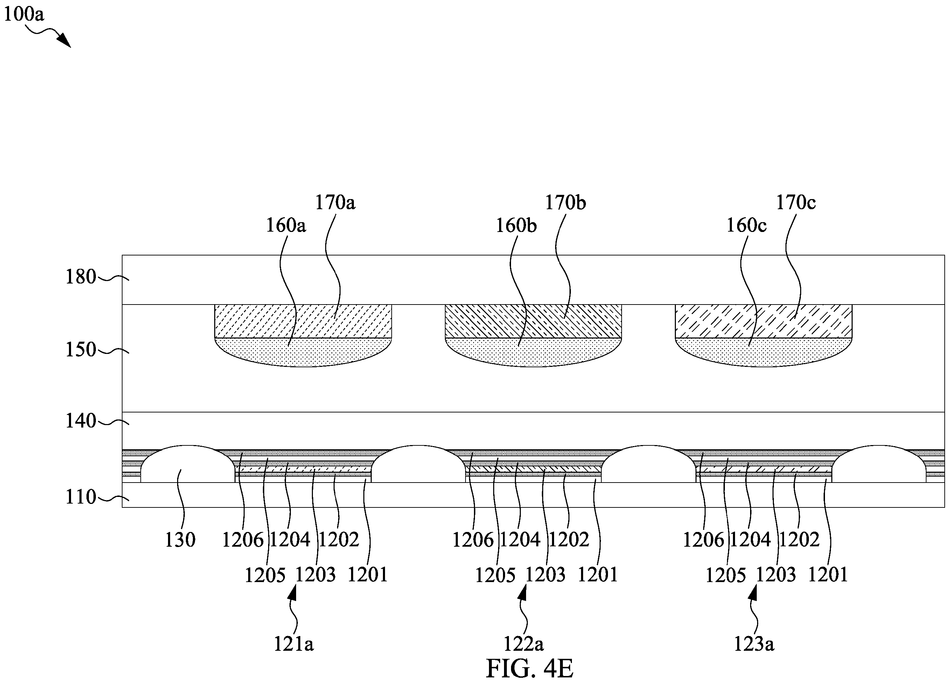

FIG. 4A, 4B, 4C, 4D and 4E are schematic views of the display device in different stages of a manufacturing process carried out with a method according to the claimed invention.

Referring to FIG. 4A, the method involves providing the substrate 110.

Referring to FIG. 4B, the method involves forming a plurality of electrodes 1201 on the substrate 110. The electrodes 1201 are formed on the substrate 110 by vapor deposition, sputtering, atomic layer deposition (ALD), evaporation, coating or jetting and patterned by photolithography technology and etching technology.

Referring to FIG. 4C, the method involves forming a dielectric layer 131 to cover the electrode 1201 and the substrate 110.

Referring to FIG. 4D, the method involves performing a patterning process P1 to pattern the dielectric layer 131, with the patterning process comprising a photolithography process and an etching process. The photolithography process includes forming a photoresist (not shown) on the dielectric layer 131, exposing the dielectric layer 131 with a reticle, developing a pattern for defining the photoresist, performing an etching process, and removing a portion of the dielectric layer 131, so as to form a pixel definition layer 130. In some embodiments, the profile of the opening of the pixel definition layer 130 meets that a ratio of the length of a long axis to the length of a short axis is greater than 1 but less than 1.25.

Referring to FIG. 4E, the method involves forming the carrier injection layer 1202, carrier transmission layer 1203, emissive layer 1204, carrier transmission layer 1205, electrode 1206, flat layer 140, filling layer 150, optical component layers 160a, 160b, 160c, filter layers 170a, 170b, 170c and cover panel 180 to obtain the display device 100a shown in FIG. 1B.

In a comparison embodiment, regarding the profile of the opening of the pixel definition layer, the ratio of the length of the longest side to the length of the shortest side (or the ratio of the length of a long axis to the length of a short axis) is greater than to 1.25 (for example, in the case of a rectangular profile). During an exposure process performed on the dielectric layer, a large error of the process is likely to cause deformation of the profile of the pixel definition layer because of a relatively high tension of the dielectric layer. In this embodiment of the disclosure, when the profile of the opening of the pixel definition layer 130 meets that a ratio of the length of a long axis to the length of a short axis is greater than 1 but less than 1.25, the deformation of the profile of the dielectric layer 131 which is otherwise caused by an error of the exposure process performed on the dielectric layer 131 is unlikely to occur.

The features of some embodiments of the disclosure are disclosed above to enable persons skilled in the art to gain insight into the disclosure. Persons skilled in the art understand that the disclosure can be used as a basis easily to design or modify other processes and structures and thereby achieve the same objectives and/or advantages as disclosed in the embodiments of the disclosure.

## Claims

1. A display device, comprising:
a first pixel (121b) adapted to emit light of a first color, wherein a profile of the first pixel is elliptical; and
a second pixel (122b) adapted to emit light of a second color, the second color being different from the first color, wherein a profile of the second pixel is round;
wherein the profile of the first pixel meets that:
a ratio of a length of a long axis (L1) to a length of a short axis (L2) is greater than 1 but less than 1.25, and wherein the first pixel has a first pixel unit (1214), a second pixel unit (1215), and a third pixel unit (1216), the first pixel unit (1214) is located at a first row, the second pixel unit (1215) is located at a second row and the third pixel unit (1216) is located at a third row, the first pixel unit is aligned with the third pixel unit along a first direction (Y) and misaligned with the second pixel unit along the first direction and a second direction (X) substantially orthogonal to the first direction,
an extending direction of a long axis of first pixel unit is nonparallel to the first direction and the second direction and is nonparallel to an extending direction of a long axis of second pixel unit, and an extending direction of a long axis of third pixel unit is parallel to the extending direction of the long axis of the first pixel unit.

2. The display device of claim 1, wherein the profile of the first pixel is different from the profile of the second pixel.

3. The display device from claim 1 or 2, wherein a profile orientation of the first pixel unit is different from a profile orientation of the second pixel unit.

4. The display device from any of claims 1-3, wherein the first pixel unit is located at a first row, and the second pixel unit is located at a second row adjacent to the first row.

5. The display device of any of the claims 1-4, wherein the third pixel unit (1216) is located at a third row adjacent to the second row, and a first distance (D2) between the first pixel unit and the third pixel unit is equal to a second distance (D5) between the first pixel unit and the second pixel unit.

6. The display device from any of claims 1 or 2, wherein a profile orientation of the third pixel unit is identical to a profile orientation of the first pixel unit.

7. The display device from any of claims 1-6, wherein the second pixel has a fourth pixel unit (1221) located at the first row and a fifth pixel unit (1222) located at the second row, and a profile of the fourth pixel unit is identical to a profile of the fifth pixel unit.

8. The display device from any of claims 1-7, wherein a size of the first pixel is different from a size of the second pixel.

9. The display device from any of claims 1-8, further comprising:
a first filter layer (170a) disposed above the first pixel,
wherein a profile of the first filter layer is elliptical and meets that:
a ratio of a length of a long axis to a length of a short axis is greater than 1 but less than 1.25.

10. The display device from any of claims 1-9, further comprising:
a pixel definition layer (130) adapted to define the profile of the first pixel,
wherein a profile of an opening of the pixel definition layer is elliptical and meets that:
a ratio of the length of a long axis to a length of a short axis is greater than 1 but less than 1.25.

11. A method of manufacturing a display device, comprising the steps of:
forming a first pixel (121a) adapted to emit light of a first color, wherein a profile of the first pixel is elliptical; and
forming a second pixel (122a) adapted to emit light of a second color, the second color being different from the first color, wherein a profile of the second pixel is round,
wherein the profile of the first pixel meets that:
a ratio of a length of a long axis to a length of a short axis is greater than 1 but less than 1.25; and
wherein the first pixel has a first pixel unit (1214), a second pixel unit (1215), and a third pixel unit (1216), the first pixel unit (1214) is located at a first row, the second pixel unit (1215) is located at a second row and the third pixel unit (1216) is located at a third row, the first pixel unit is aligned with the third pixel unit along a first direction and misaligned with the second pixel unit along the first direction and a second direction substantially orthogonal to the first direction,
an extending direction of a long axis of first pixel unit is nonparallel to the first direction and the second direction and is nonparallel to an extending direction of a long axis of second pixel unit, and an extending direction of a long axis of third pixel unit is parallel to the extending direction of the long axis of the first pixel unit.

12. The method of claim 11, further comprising the steps of:
providing a substrate (110);
forming a dielectric layer (131) on the substrate; and
patterning the dielectric layer to form a pixel definition layer (130) adapted to define the profile of the first pixel and the profile of the second pixel,
wherein a profile of an opening of the pixel definition layer is elliptical and meets that:
a ratio of a length of a long axis to a length of a short axis is greater than 1 but less than 1.25.

13. The method from claim 11 or 12, further comprising the step of:
forming a first filter layer (170a) above the first pixel,
wherein a profile of the first filter layer is elliptical and meets that:
a ratio of a length of a long axis to a length of a short axis is greater than 1 but less than 1.25.

14. The method from any of claims 11-13, further comprising the step of:
forming a second filter layer (170b) above the second pixel, wherein a profile of the second filter layer is different from the profile of the first filter layer.

15. The method from any of claims 11-14, wherein the profile of the first pixel is different from the profile of the second pixel.

## Patentansprüche

1. Anzeigeeinrichtung, aufweisend:
ein erstes Pixel (121b), das dazu ausgelegt ist, Licht einer ersten Farbe zu emittieren, wobei ein Profil des ersten Pixels elliptisch ist; und
ein zweites Pixel (122b), das dazu ausgelegt ist, Licht einer zweiten Farbe zu emittieren, wobei die zweite Farbe von der ersten Farbe verschieden ist und ein Profil des zweiten Pixels rund ist;
wobei das Profil des ersten Pixels erfüllt, dass:
ein Verhältnis einer Länge einer langen Achse (L1) zu einer Länge einer kurzen Achse (L2) größer als 1, jedoch kleiner als 1,25 ist, und wobei das erste Pixel eine erste Pixeleinheit (1214), eine zweite Pixeleinheit (1215) und eine dritte Pixeleinheit (1216) aufweist, die erste Pixeleinheit (1214) sich in einer ersten Zeile befindet, die zweite Pixeleinheit (1215) sich in einer zweiten Zeile befindet und die dritte Pixeleinheit (1216) sich in einer dritten Zeile befindet, die erste Pixeleinheit entlang einer ersten Richtung (Y) mit der dritten Pixeleinheit ausgerichtet ist und entlang der ersten Richtung und einer zweiten Richtung (X), die im Wesentlichen orthogonal zu der ersten Richtung ist, gegenüber der zweiten Pixeleinheit versetzt ist,
wobei eine Erstreckungsrichtung einer langen Achse der ersten Pixeleinheit nicht parallel zu der ersten Richtung und der zweiten Richtung ist und nicht parallel zu einer Erstreckungsrichtung einer langen Achse der zweiten Pixeleinheit ist und eine Erstreckungsrichtung einer langen Achse der dritten Pixeleinheit parallel zu der Erstreckungsrichtung der langen Achse der ersten Pixeleinheit ist.

2. Anzeigeeinrichtung nach Anspruch 1, wobei das Profil des ersten Pixels von dem Profil des zweiten Pixels verschieden ist.

3. Anzeigeeinrichtung nach Anspruch 1 oder 2, wobei eine Profilausrichtung der ersten Pixeleinheit von einer Profilausrichtung der zweiten Pixeleinheit verschieden ist.

4. Anzeigeeinrichtung nach einem der Ansprüche 1 bis 3, wobei sich die erste Pixeleinheit in einer ersten Zeile befindet und sich die zweite Pixeleinheit in einer zweiten Zeile befindet, die zu der ersten Zeile benachbart ist.

5. Anzeigeeinrichtung nach einem der Ansprüche 1 bis 4, wobei sich die dritte Pixeleinheit (1216) in einer dritten Zeile befindet, die zu der zweiten Zeile benachbart ist, und ein erster Abstand (D2) zwischen der ersten Pixeleinheit und der dritten Pixeleinheit gleich einem zweiten Abstand (D5) zwischen der ersten Pixeleinheit und der zweiten Pixeleinheit ist.

6. Anzeigeeinrichtung nach einem der Ansprüche 1 oder 2, wobei eine Profilausrichtung der dritten Pixeleinheit mit einer Profilausrichtung der ersten Pixeleinheit identisch ist.

7. Anzeigeeinrichtung nach einem der Ansprüche 1 bis 6, wobei das zweite Pixel eine vierte Pixeleinheit (1221), die sich in der ersten Zeile befindet, und eine fünfte Pixeleinheit (1222), die sich in der zweiten Zeile befindet, aufweist und ein Profil der vierten Pixeleinheit mit einem Profil der fünften Pixeleinheit identisch ist.

8. Anzeigeeinrichtung nach einem der Ansprüche 1 bis 7, wobei eine Größe des ersten Pixels von einer Größe des zweiten Pixels verschieden ist.

9. Anzeigeeinrichtung nach einem der Ansprüche 1 bis 8, ferner aufweisend:
eine erste Filterschicht (170a), die über dem ersten Pixel angeordnet ist,
wobei ein Profil der ersten Filterschicht elliptisch ist und erfüllt, dass:
ein Verhältnis einer Länge einer langen Achse zu einer Länge einer kurzen Achse größer als 1, jedoch kleiner als 1,25 ist.

10. Anzeigeeinrichtung nach einem der Ansprüche 1 bis 9, ferner aufweisend:
eine Pixeldefinitionsschicht (130), die dazu ausgelegt ist, das Profil des ersten Pixels zu definieren,
wobei ein Profil einer Öffnung der Pixeldefinitionsschicht elliptisch ist und erfüllt, dass:
ein Verhältnis der Länge einer langen Achse zu einer Länge einer kurzen Achse größer als 1, jedoch kleiner als 1,25 ist.

11. Verfahren zum Herstellen einer Anzeigeeinrichtung, umfassend die Schritte:
Bilden eines ersten Pixels (121a), das dazu ausgelegt ist, Licht einer ersten Farbe zu emittieren, wobei ein Profil des ersten Pixels elliptisch ist; und
Bilden eines zweiten Pixels (122a), das dazu ausgelegt ist, Licht einer zweiten Farbe zu emittieren, wobei die zweite Farbe von der ersten Farbe verschieden ist und ein Profil des zweiten Pixels rund ist,
wobei das Profil des ersten Pixels erfüllt, dass:
ein Verhältnis einer Länge einer langen Achse zu einer Länge einer kurzen Achse größer als 1, jedoch kleiner als 1,25 ist; und
wobei das erste Pixel eine erste Pixeleinheit (1214), eine zweite Pixeleinheit (1215) und eine dritte Pixeleinheit (1216) aufweist, die erste Pixeleinheit (1214) sich in einer ersten Zeile befindet, die zweite Pixeleinheit (1215) sich in einer zweiten Zeile befindet und die dritte Pixeleinheit (1216) sich in einer dritten Zeile befindet, die erste Pixeleinheit entlang einer ersten Richtung mit der dritten Pixeleinheit ausgerichtet ist und entlang der ersten Richtung und einer zweiten Richtung, die im Wesentlichen orthogonal zu der ersten Richtung ist, gegenüber der zweiten Pixeleinheit versetzt ist,
wobei eine Erstreckungsrichtung einer langen Achse der ersten Pixeleinheit nicht parallel zu der ersten Richtung und der zweiten Richtung ist und nicht parallel zu einer Erstreckungsrichtung einer langen Achse der zweiten Pixeleinheit ist und eine Erstreckungsrichtung einer langen Achse der dritten Pixeleinheit parallel zu der Erstreckungsrichtung der langen Achse der ersten Pixeleinheit ist.

12. Verfahren nach Anspruch 11, ferner umfassend die Schritte:
Bereitstellen eines Substrats (110);
Bilden einer dielektrischen Schicht (131) auf dem Substrat; und
Strukturieren der dielektrischen Schicht, um eine Pixeldefinitionsschicht (130) zu bilden, die dazu ausgelegt ist, das Profil des ersten Pixels und das Profil des zweiten Pixels zu definieren,
wobei ein Profil einer Öffnung der Pixeldefinitionsschicht elliptisch ist und erfüllt, dass:
ein Verhältnis einer Länge einer langen Achse zu einer Länge einer kurzen Achse größer als 1, jedoch kleiner als 1,25 ist.

13. Verfahren nach Anspruch 11 oder 12, ferner umfassend den Schritt:
Bilden einer ersten Filterschicht (170a) über dem ersten Pixel,
wobei ein Profil der ersten Filterschicht elliptisch ist und erfüllt, dass:
ein Verhältnis einer Länge einer langen Achse zu einer Länge einer kurzen Achse größer als 1, jedoch kleiner als 1,25 ist.

14. Verfahren nach einem der Ansprüche 11 bis 13, ferner umfassend den Schritt:
Bilden einer zweiten Filterschicht (170b) über dem zweiten Pixel, wobei ein Profil der zweiten Filterschicht von dem Profil der ersten Filterschicht verschieden ist.

15. Verfahren nach einem der Ansprüche 11 bis 14, wobei das Profil des ersten Pixels von dem Profil des zweiten Pixels verschieden ist.

## Revendications

1. Dispositif d'affichage, comprenant:
un premier pixel (121b) conçu pour émettre une lumière d'une première couleur, dans lequel un profil du premier pixel est elliptique; et
un deuxième pixel (122b) conçu pour émettre une lumière d'une deuxième couleur, la deuxième couleur étant différente de la première couleur, dans lequel un profil du deuxième pixel est rond;
dans lequel le profil du premier pixel répond à ce qui suit:
un rapport entre une longueur d'un axe long (L1) et une longueur d'un axe court (L2) est supérieur à 1 mais inférieur à 1,25, et dans lequel le premier pixel comporte une première unité de pixel (1214), une deuxième unité de pixel (1215), et une troisième unité de pixel (1216), la première unité de pixel (1214) est située au niveau d'une première rangée, la deuxième unité de pixel (1215) est située au niveau d'une deuxième rangée et la troisième unité de pixel (1216) est située au niveau d'une troisième rangée, la première unité de pixel est alignée avec la troisième unité de pixel le long d'une première direction (Y) et désalignée avec la deuxième unité de pixel le long de la première direction et d'une deuxième direction (X) sensiblement orthogonale à la première direction,
une direction d'extension d'un axe long de la première unité de pixel n'est pas parallèle à la première direction et à la deuxième direction et n'est pas parallèle à une direction d'extension d'un axe long de la deuxième unité de pixel, et une direction d'extension d'un axe long de la troisième unité de pixel est parallèle à la direction d'extension de l'axe long de la première unité de pixel.

2. Dispositif d'affichage selon la revendication 1, dans lequel le profil du premier pixel est différent du profil du deuxième pixel.

3. Dispositif d'affichage selon la revendication 1 ou 2, dans lequel une orientation de profil de la première unité de pixel est différente d'une orientation de profil de la deuxième unité de pixel.

4. Dispositif d'affichage selon l'une quelconque des revendications 1 à 3, dans lequel la première unité de pixel est située au niveau d'une première rangée, et la deuxième unité de pixel est située au niveau d'une deuxième rangée adjacente à la première rangée.

5. Dispositif d'affichage selon l'une quelconque des revendications 1 à 4, dans lequel la troisième unité de pixel (1216) est située au niveau d'une troisième rangée adjacente à la deuxième rangée, et une première distance (D2) entre la première unité de pixel et la troisième unité de pixel est égale à une deuxième distance (D5) entre la première unité de pixel et la deuxième unité de pixel.

6. Dispositif d'affichage selon l'une quelconque des revendications 1 ou 2, dans lequel une orientation de profil de la troisième unité de pixel est identique à une orientation de profil de la première unité de pixel.

7. Dispositif d'affichage selon l'une quelconque des revendications 1 à 6, dans lequel le deuxième pixel comporte une quatrième unité de pixel (1221) située au niveau de la première rangée et une cinquième unité de pixel (1222) située au niveau de la deuxième rangée, et un profil de la quatrième unité de pixel est identique à un profil de la cinquième unité de pixel.

8. Dispositif d'affichage selon l'une quelconque des revendications 1 à 7, dans lequel une taille du premier pixel est différente d'une taille du deuxième pixel.

9. Dispositif d'affichage selon l'une quelconque des revendications 1 à 8, comprenant en outre:
une première couche filtrante (170a) disposée au-dessus du premier pixel,
dans lequel un profil de la première couche filtrante est elliptique et répond à ce qui suit:
un rapport entre une longueur d'un axe long et une longueur d'un axe court est supérieur à 1 mais inférieur à 1,25.

10. Dispositif d'affichage selon l'une quelconque des revendications 1 à 9, comprenant en outre:
une couche de définition de pixel (130) conçue pour définir le profil du premier pixel,
dans lequel un profil d'une ouverture de la couche de définition de pixel est elliptique et répond à ce qui suit:
un rapport entre la longueur d'un axe long et une longueur d'un axe court est supérieur à 1 mais inférieur à 1,25.

11. Procédé de fabrication d'un dispositif d'affichage, comprenant les étapes suivantes:
la formation d'un premier pixel (121a) conçu pour émettre une lumière d'une première couleur, dans lequel un profil du premier pixel est elliptique; et
la formation d'un deuxième pixel (122a) conçu pour émettre une lumière d'une deuxième couleur, la deuxième couleur étant différente de la première couleur, dans lequel un profil du deuxième pixel est rond,
dans lequel le profil du premier pixel répond à ce qui suit:
un rapport entre une longueur d'un axe long et une longueur d'un axe court est supérieur à 1 mais inférieur à 1,25; et
dans lequel le premier pixel comporte une première unité de pixel (1214), une deuxième unité de pixel (1215), et une troisième unité de pixel (1216), la première unité de pixel (1214) est située au niveau d'une première rangée, la deuxième unité de pixel (1215) est située au niveau d'une deuxième rangée et la troisième unité de pixel (1216) est située au niveau d'une troisième rangée, la première unité de pixel est alignée avec la troisième unité de pixel le long d'une première direction et désalignée avec la deuxième unité de pixel le long de la première direction et d'une deuxième direction sensiblement orthogonale à la première direction,
une direction d'extension d'un axe long de la première unité de pixel n'est pas parallèle à la première direction et à la deuxième direction et n'est pas parallèle à une direction d'extension d'un axe long de la deuxième unité de pixel, et une direction d'extension d'un axe long de la troisième unité de pixel est parallèle à la direction d'extension de l'axe long de la première unité de pixel.

12. Procédé selon la revendication 11, comprenant en outre les étapes suivantes:
la fourniture d'un substrat (110);
la formation d'une couche diélectrique (131) sur le substrat; et
la formation de motifs sur la couche diélectrique pour former une couche de définition de pixel (130) conçue pour définir le profil du premier pixel et le profil du deuxième pixel,
dans lequel le profil d'une ouverture de la couche de définition de pixel est elliptique et répond à ce qui suit:
un rapport entre une longueur d'un axe long et une longueur d'un axe court est supérieur à 1 mais inférieur à 1,25.

13. Procédé selon la revendication 11 ou 12, comprenant en outre l'étape suivante:
la formation d'une première couche filtrante (170a) au-dessus du premier pixel,
dans lequel un profil de la première couche filtrante est elliptique et répond à ce qui suit:
un rapport entre une longueur d'un axe long et une longueur d'un axe court est supérieur à 1 mais inférieur à 1,25.

14. Procédé selon l'une quelconque des revendications 11 à 13, comprenant en outre l'étape suivante:
la formation d'une deuxième couche filtrante (170b) au-dessus du deuxième pixel, dans lequel un profil de la deuxième couche filtrante est différent du profil de la première couche filtrante.

15. Procédé selon l'une quelconque des revendications 11 à 14, dans lequel le profil du premier pixel est différent du profil du deuxième pixel.
